# FASCICULE DE BREVET EUROPEEN

(11) **EP 3 948 941 B1**
(45) Date de publication et mention de la délivrance du brevet: **22.03.2023**
(21) Numéro de dépôt: 20713004.8
(22) Date de dépôt: 26.03.2020
(51) Int. Cl.: H01L 21/762

(54) **PROCEDE DE FABRICATION D'UN SUBSTRAT DE TYPE SEMI-CONDUCTEUR SUR ISOLANT**
VERFAHREN ZUR HERSTELLUNG EINES HALBLEITER-AUF-ISOLATOR-SUBSTRATS
METHOD FOR MANUFACTURING A SEMICONDUCTOR-ON-INSULATOR SUBSTRATE

(30) Priorité: 29.03.2019 FR 1903387
(43) Date de publication de la demande: 09.02.2022
(73) Titulaire: SOITEC, 38190 Bernin (FR)
(72) Inventeur: BROEKAART, Marcel, 38570 Theys (FR); CASTEX, Arnaud, 38100 Grenoble (FR)
(74) Mandataire: Regimbeau
(86) Numéro de dépôt international: PCT/EP2020/058529
(87) Numéro de publication internationale: WO 2020/201003

(56) Documents cités:
- FR-A1- 2 894 067
- US-A1- 2008 200 008
- US-A1- 2015 079 759
- F. RIEUTORD ET AL: "Dynamics of a Bonding Front", PHYSICAL REVIEW LETTERS, vol. 94, no. 23, 1 juin 2005 (2005-06-01), XP055495602, US ISSN: 0031-9007, DOI: 10.1103/PhysRevLett.94.236101

## Description

### DOMAINE TECHNIQUE DE L'INVENTION

La présente invention concerne un procédé de fabrication une structure de type semi-conducteur sur isolant par transfert d'une couche d'un premier substrat, dit « substrat donneur », sur un deuxième substrat, dit « substrat receveur ».

### ETAT DE LA TECHNIQUE

Les structures de type semi-conducteur sur isolant sont des structures multicouches comprenant un substrat support, une couche électriquement isolante agencée sur le substrat support, qui est généralement une couche d'oxyde telle qu'une couche d'oxyde de silicium, et une couche semi-conductrice agencée sur la couche isolante dans laquelle sont réalisées des zones fonctionnelles de la structure.

De telles structures sont dites structures « Semiconductor on Insulator » (acronyme SeOI) en anglais, en particulier « Silicon on Insulator » (SOI) lorsque le matériau semi-conducteur est du silicium. Un procédé connu pour fabriquer ce type de structure est le procédé SmartCut^{®} qui consiste à former une zone de fragilisation dans un premier substrat semi-conducteur, dit « substrat donneur » de manière à délimiter une couche semi-conductrice à transférer. La zone de fragilisation est formée dans le substrat donneur à une profondeur prédéterminée qui correspond sensiblement à l'épaisseur de la couche à transférer.

La couche à transférer est ensuite transférée sur un deuxième substrat semi-conducteur, qui est dit « substrat receveur » ou « substrat support », par collage du substrat donneur sur le substrat receveur par l'intermédiaire de la couche à transférer, puis détachement du substrat donneur le long de la zone de fragilisation.

Le détachement du substrat donneur peut être réalisé par recuit thermique de la structure formée par le substrat donneur et le substrat receveur. Ce type de détachement est communément appelé « thermal splitting » en anglais (détachement thermique en français), ou par son acronyme « T-split ».

L'amorçage de l'onde de détachement est déterminé par la maturation de différentes zones au sein du substrat donneur et du substrat receveur, au voisinage de la zone de fragilisation. La température au sein du substrat donneur et du substrat receveur est hétérogène, de sorte qu'il se forme des zones de haute température, dites zones chaudes, et des zones à plus basse température, dites zones froides. Ces différences de température entrainent une maturation différenciée des zones chaudes et des zones froides, c'est-à-dire que la maturation des zones chaudes est plus importante que celle des zones froides.

L'amorçage de l'onde de détachement est réalisé lorsque la maturation des zones chaudes est suffisante.

Cependant, les disparités de température et de maturation au sein du matériau du substrat donneur et du substrat receveur d'une part créent un motif (« pattern » en anglais) de rugosité sur la surface exposée du substrat SeOI obtenu après détachement du substrat donneur, et d'autre part limitent le contrôle du détachement du fait de l'énergie libérée par les zones chaudes arrivées à maturation. Il est alors nécessaire de recourir à des traitements ultérieurs de lissage, tel que le RTA (recuit thermique rapide ou « Rapid Thermal Annealing » en anglais), afin de réduire la forte rugosité de la surface libre de la structure après détachement, ce qui engendre des coûts de production élevés en plus de rallonger le temps de production.

Par ailleurs, le détachement thermique présente plusieurs autres inconvénients. En particulier, lorsque le substrat donneur et/ou le substrat receveur comprend des composants électroniques, ces derniers sont susceptibles d'être dégradés lorsqu'ils sont soumis à des températures élevées, ce qui limite fortement la fabrication de certains substrats SeOI.

Le document FR 2 894 067 décrit la fabrication d'une structure semi-conducteur-sur-isolant dans lequel on contrôle la propagation de l'onde de collage.

### BREVE DESCRIPTION DE L'INVENTION

Un but de l'invention est de surmonter les inconvénients détaillés précédemment.

L'invention vise notamment à fournir un procédé de fabrication d'un substrat de type semi-conducteur sur isolant, par transfert d'une couche d'un substrat donneur sur un substrat receveur, permettant de réduire la rugosité de la surface exposée du substrat SeOI obtenu après détachement du substrat donneur.

L'invention a également pour but de fournir un tel procédé, permettant de s'affranchir des contraintes qui résultent du détachement thermique, notamment de fournir un procédé plus économique et qui soit compatible avec la fabrication d'une plus grande variété de substrats SeOI.

A cet effet, l'invention concerne un procédé de fabrication d'une structure de type semi-conducteur sur isolant, comprenant les étapes suivantes :
- fourniture d'un substrat donneur comprenant une zone de fragilisation délimitant une couche à transférer,
- fourniture d'un substrat receveur,
- collage du substrat donneur sur le substrat receveur, la couche à transférer étant située du côté de l'interface de collage, par initiation d'une onde de collage à partir d'une première région de la périphérie de ladite interface et propagation de ladite onde vers une seconde région de la périphérie de ladite interface opposée à la première région, la vitesse de propagation de l'onde de collage étant plus faible dans ladite partie centrale que dans ladite partie périphérique,
- détachement du substrat donneur le long de la zone de fragilisation pour transférer la couche à transférer sur le substrat receveur,
ledit procédé étant caractérisé en ce que le collage est mis en oeuvre dans des conditions contrôlées pour augmenter la différence de vitesse de propagation de ladite onde de collage entre la partie périphérique et la partie centrale de l'interface de collage.

Selon d'autres aspects, le procédé proposé présente les différentes caractéristiques suivantes prises seules ou selon leurs combinaisons techniquement possibles :
- l'augmentation de la différence de vitesse de propagation de l'onde de collage est suffisante pour former une inclusion gazeuse dans la seconde région de la périphérie de l'interface de collage ;
- le détachement du substrat donneur est amorcé au niveau de l'inclusion gazeuse ;
- les conditions de collage contrôlées comprennent le positionnement du substrat donneur et/ou du substrat receveur, préalablement au collage, sur une surface d'appui d'un support, ladite surface d'appui présentant une zone surélevée par rapport au reste de la surface d'appui, la surface exposée du substrat donneur et/ou du substrat receveur destinée à former l'interface de collage étant au moins partiellement conformée à la surface d'appui du support de manière à présenter une zone surélevée par rapport au reste de la surface exposée ;
- la zone surélevée de la surface exposée du substrat donneur et/ou du substrat receveur est surélevée par rapport au reste de la surface exposée de 15 µm à 150 µm ;
- les conditions de collage contrôlées comprennent l'application sélective d'un plasma sur la surface exposée du substrat donneur et/ou du substrat receveur destinée à former l'interface de collage, la quantité de plasma appliquée sur la partie périphérique de ladite surface exposée étant supérieure à celle appliquée sur la partie centrale de ladite surface exposée ;
- la zone de fragilisation est formée par implantation d'espèces atomiques dans le substrat donneur.

### BREVE DESCRIPTION DES FIGURES

D'autres avantages et caractéristiques de l'invention apparaîtront à la lecture de la description suivante donnée à titre d'exemple illustratif et non limitatif, en référence aux figures annexées suivantes :
- la figure 1 est une représentation schématique en vue du dessus qui illustre la propagation d'une onde collage à l'interface de collage ;
- la figure 2 est un graphe de Haze, obtenu par diffraction d'un laser sur la surface de deux structures de type semi-conducteur sur isolant obtenues après détachement et lissage thermique par recuit thermique ;
- la figure 3A est une vue du dessus d'un substrat donneur ou receveur illustrant la localisation d'une inclusion de gaz ;
- la figure 3B représente quatre substrats en vue du dessus, avec quatre inclusions gazeuses à l'interface de collage ;
- la figure 4 est une vue rapprochée d'une inclusion de gaz illustrant ses dimensions ;
- la figure 5 est une photographie en vue du dessus d'un support, ou « chuch » en anglais ;
- la figure 6 est un schéma du support de la figure 5 ;
- la figure 7 est une vue de côté du support de la figure 5 ;
- la figure 8 est une vue de côté en coupe au microscope optique du support de la figure 5 ;
- la figure 9 est une représentation schématique d'un support sur lequel sont montés un substrat donneur et un substrat receveur, avant collage ;
- la figure 10 est une représentation schématique d'un support sur lequel sont montés un substrat donneur et un substrat receveur, après collage ;
- la figure 11 est une vue de côté en coupe au microscope optique du support de la figure 5 illustrant le décollement localisé de son revêtement en TEFLON^{™} ;
- la figure 12 est une distribution de points illustrant le profil de la surface d'appui du support après déformation, selon trois axes x, y, z ;
- la figure 13 est une représentation en perspective selon les axes x, y, z d'une mesure de planarité du support, qui illustre la déformation de la surface d'appui du support au niveau de la zone de terminaison de l'onde de collage ;
- la figure 14 est une vue de la figure 13 selon les axes x et y uniquement.

### DESCRIPTION DETAILLEE DE MODES DE REALISATION DE L'INVENTION

L'invention concerne un procédé de fabrication d'une structure de type semi-conducteur sur isolant, dans lequel un premier substrat, dit substrat donneur, est collé sur un deuxième substrat, dit substrat receveur. Le substrat donneur comprend une zone de fragilisation qui délimite la couche à transférer.

Lors du collage, la couche à transférer vient en contact avec la surface libre du substrat receveur, de sorte que la surface libre de ladite couche à transférer et la surface libre du substrat receveur forment l'interface de collage.

Un traitement thermique est éventuellement mis en oeuvre pour augmenter l'énergie de collage entre les deux substrats.

Le substrat donneur est ensuite détaché le long de la zone de fragilisation. Une fracture est initiée puis se propage au niveau de la zone de fragilisation, qui est par nature une zone de plus grande fragilité du substrat donneur. La couche délimitée à la surface du substrat donneur est ainsi transférée sur le substrat receveur. La fracture peut se déclencher spontanément en chauffant l'assemblage des substrats à une température donnée, ou bien être déclenchée en appliquant au substrat donneur une contrainte mécanique.

Le procédé de transfert de couche peut être notamment de type Smart Cut^{™}, dans lequel la zone de fragilisation est créée par implantation d'espèces atomiques, notamment d'atomes d'hydrogène et/ou d'hélium, dans le substrat donneur à une profondeur déterminée par les paramètres d'implantation qui correspond sensiblement à l'épaisseur de la couche à transférer. L'homme du métier est en mesure de déterminer les paramètres d'implantation, notamment la nature des espèces atomiques, la dose et l'énergie des espèces, afin d'implanter les espèces atomiques à la profondeur souhaitée dans le substrat donneur.

Le procédé Smart Cut^{™} est avantageux car il permet de réutiliser le substrat donneur après transfert de la couche pour d'autres applications ultérieures, et permet de transférer des couches minces de manière uniforme.

Lors du collage du substrat donneur avec le substrat receveur, les deux substrats sont mis en contact au niveau de leur périphérie. La zone de contact des substrats donneur et receveur est le lieu d'amorçage d'une onde de collage, et constitue une première région périphérique de l'interface de collage.

Le substrat donneur et le substrat receveur sont rapprochés l'un de l'autre de manière à se recouvrir, depuis la première région périphérique de l'interface de collage. L'onde de collage se déplace alors le long de l'interface de collage formée par les surfaces libres respectives du substrat donneur et du substrat receveur qui entrent en contact, depuis la première région de la périphérie de ladite interface, vers une seconde région de la périphérie de ladite interface opposée à la première région par rapport à un plan médian perpendiculaire aux substrats assemblés. Autrement dit, lorsque les substrats sont en forme de disques, la seconde région est diamétralement opposée à la première région, et est le lieu de terminaison de l'onde de collage.

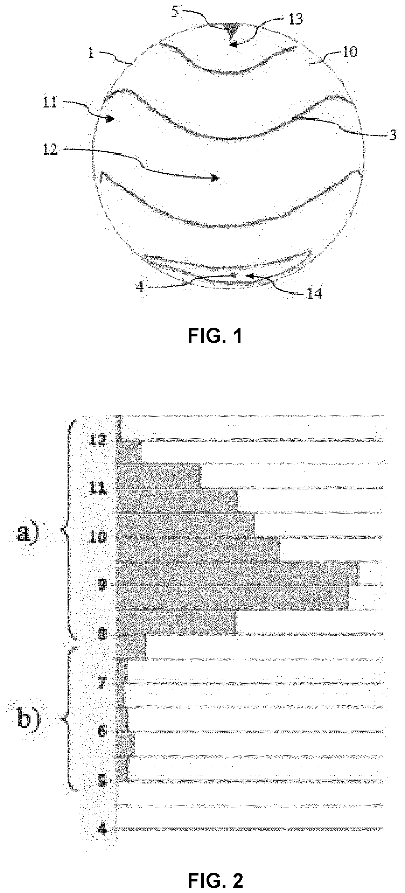

Le procédé de fabrication de l'invention repose sur l'observation expérimentale suivante, illustrée par la figure 1. Comme l'illustre la figure 1, lors du collage du substrat donneur 1 avec le substrat receveur 2, l'onde de collage 3 se propage plus rapidement au niveau de la périphérie 11 de l'interface de collage 10 qu'au niveau de la partie centrale 12 de ladite interface.

La périphérie 11 de l'interface de collage correspond à la partie de l'interface située entre le bord du substrat donneur et le bord du substrat receveur, qui s'étend entre le lieu d'amorçage 13 de l'onde de collage et le lieu de terminaison 14 de l'onde de collage. La partie centrale 12 de l'interface de collage correspond à une région voisine du centre des deux substrats assemblés, qui s'étend entre le lieu d'amorçage 13 de l'onde de collage et le lieu de terminaison 14 de l'onde de collage. En notant Vp la vitesse de l'onde de collage à la périphérie de l'interface de collage et Vc la vitesse de l'onde de collage au centre de l'interface de collage, il existe une relation de proportionnalité entre Vp et Vc définie par la relation suivante : Vp = 1,585*Vc (1).

La différence de vitesse de l'onde de collage 3 entre la partie centrale 12 et la partie périphérique 11 de l'interface de collage est principalement due au fait que, lorsque le substrat donneur 1 et le substrat receveur 2 sont rapprochés l'un de l'autre, le volume d'air situé entre les deux substrats est évacué plus rapidement au niveau de la partie périphérique qu'au niveau de la partie centrale de l'interface. En revanche, la distance que doit parcourir l'onde de collage est plus importante au niveau de la partie périphérique qu'au niveau de la partie centrale de l'interface de collage.

Ainsi, l'onde de collage 3 met sensiblement le même temps pour parvenir jusqu'au lieu de terminaison 14, que celle-ci se propage par le centre 12 ou par la périphérie 11 de l'interface de collage 10.

De manière surprenante, le demandeur a remarqué qu'en accentuant la différence de vitesse de propagation de l'onde de collage entre la partie périphérique 11 et la partie centrale 12 de l'interface de collage, le détachement ultérieur du substrat donneur 1 est facilité et conduit à une réduction de la rugosité de la surface libre de la structure de type-semi-conducteur sur isolant obtenue.

De manière préférée, en reprenant la relation (1) précédente, on accentue la différence de vitesse de l'onde de collage entre la partie périphérique et la partie centrale de l'interface de collage, conformément à la relation (2) suivante : Vp > 1.585*Vc (2).

Lorsque l'on accentue la différence de vitesse de propagation de l'onde de collage 3 entre la partie périphérique 11 et la partie centrale 12 de l'interface de collage, en particulier en vérifiant la relation (2), il se forme une inclusion gazeuse 4, notamment d'air, au niveau de la seconde région de la périphérie de l'interface de collage. L'inclusion gazeuse se forme donc à l'interface de collage, au niveau du lieu de terminaison 14 de l'onde de collage, à l'opposé du lieu d'amorçage 13.

De manière empirique, le demandeur a constaté que l'inclusion gazeuse se forme à partir de 2,5 mm et jusqu'à 4 mm du bord de l'interface de collage.

Une telle inclusion n'est pas observée dans un procédé de collage conventionnel.

Sur la figure 1, une inclusion gazeuse 4 est représentée à la périphérie du substrat receveur 2, et est diamétralement opposée à une encoche 5, dite « notch » en anglais, à partir de laquelle est initié le collage des substrats. Une telle encoche est bien connue dans le domaine des substrats de type semi-conducteur sur isolant et sert à repérer le positionnement relatif des substrats. Le déplacement de l'onde de collage est schématisé par les lignes courbes 3 dont le sommet de la courbure pointe vers le lieu de terminaison 14 où se situe l'inclusion gazeuse.

Lorsque le collage est réalisé en présence d'un ou plusieurs gaz autres que de l'air, tels que l'azote ou l'argon, ces gaz peuvent également être emprisonnés dans l'inclusion gazeuse.

La présence d'une ou plusieurs inclusions gazeuses 4 à l'interface de collage 10 facilite le détachement ultérieur du substrat donneur. Plus précisément, les inclusions gazeuses déstabilisent l'interface de collage. Ainsi, lorsque le détachement est amorcé, notamment par recuit thermique et/ou contrainte mécanique, les inclusions gazeuses constituent des zones de fracture privilégiées. La fracture est initiée au niveau de la zone de fragilisation à la périphérie du substrat donneur, et se propage ensuite le long de la zone de fragilisation. En parallèle, la fracture est également initiée au niveau des inclusions gazeuses, et se propage depuis les inclusions gazeuses vers la zone de fragilisation, ce qui induit un effet de synergie qui optimise la fracturation du substrat donneur au niveau de la zone de fragilisation.

Les contraintes mécaniques au niveau de la zone de fragilisation sont moindres comparativement aux procédés connus dans lesquels la vitesse de propagation de l'onde de collage n'est pas contrôlée conformément au procédé de l'invention, ce qui conduit à une amélioration, c'est-à-dire à une diminution, de la rugosité de la surface libre de la structure de type semi-conducteur sur isolant obtenue après détachement du substrat donneur.

Cette amélioration de la rugosité peut être constatée grâce au graphe de rugosité illustré sur la figure 2, dit graphe de Haze, obtenu par diffraction d'un laser sur la surface de deux structures de type semi-conducteur sur isolant obtenues après détachement et lissage thermique par recuit thermique. Une première structure a) est obtenue par la réalisation d'un procédé de fabrication selon l'état de l'art, dit « T-split » et une deuxième structure b) est obtenue par la réalisation du procédé de fabrication de l'invention b), dit « D-split ».

Le haze mesuré sur la surface de la structure a) est très hétérogène. Ceci est illustré sur le graphe par la présence importante et majoritaire d'un haze environ égal à 9, relativement importante entre 8 et 9 et entre 9 et 11, et moins importante entre 7 et 8 et entre 11 et 12.

Le haze mesuré sur la surface de la structure b) est nettement plus homogène. Ceci est illustré sur le graphe par un haze plus faible et sensiblement de même distribution entre 5 et 7.

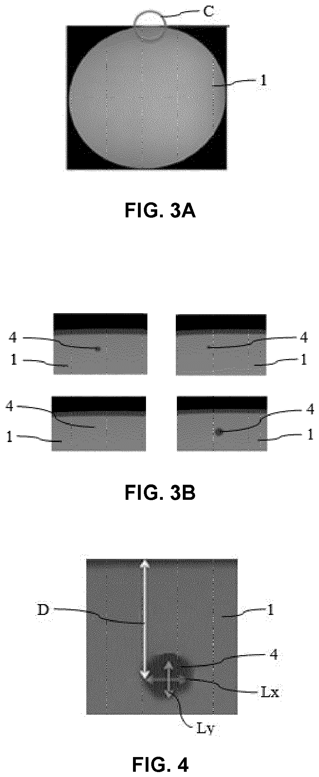

Les figures 3A et 3B illustrent le positionnement de plusieurs inclusions gazeuses 4. La figure 3A montre que les inclusions gazeuses se trouvent à la périphérie 11 de l'interface de collage. Les inclusions gazeuses sont entourées par un cercle C. En particulier, sur la figure 3B, les inclusions gazeuses 4 se situent à proximité du bord des substrats collés, à l'interface de collage 10.

La figure 4 schématise les dimensions Lx et Ly d'une inclusion de gaz 4, selon deux axes x et y perpendiculaires entre eux et parallèles au plan de l'interface de collage 10, ainsi que sa distance D par rapport au bord du substrat. Les valeurs correspondantes sont indiquées dans le tableau ci-dessous. Dans le tableau sont également indiqués la surface S de l'inclusion ainsi que le haze. Les mesures ont été faites sur plusieurs inclusions de gaz. Le tableau indique les valeurs moyennes minimum (min) et maximum (max) des différentes caractéristiques de ces inclusions de gaz.

**Tableau : caractéristiques de plusieurs inclusions de gaz**

| | **Lx (mm)** | **Ly (mm)** | **S (mm²)** | **D (mm)** | **Haze** |
|---|---|---|---|---|---|
| **Min** | 0,1894 | 0,2622 | 0,1615 | 2,7463 | 5,45 |
| **Max** | 1,4112 | 1,2350 | 5,1023 | 4,2570 | 6,46 |

Deux modes de réalisation permettant d'accentuer la différence de vitesse de propagation de l'onde de collage entre la partie périphérique et la partie centrale de l'interface de collage vont maintenant être présentés.

Selon un premier mode de réalisation, on positionne le substrat donneur 1 et/ou le substrat receveur 2, préalablement au collage, sur une surface d'appui 21 d'un support 20 ou « chuck » en anglais.

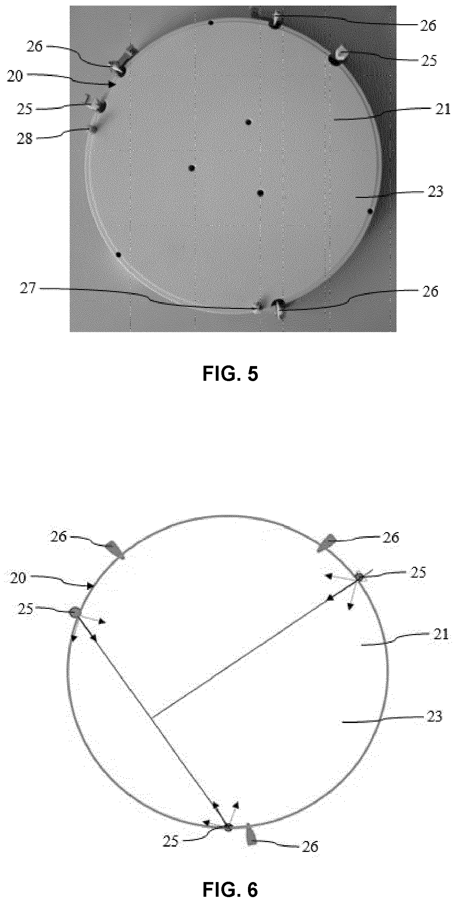

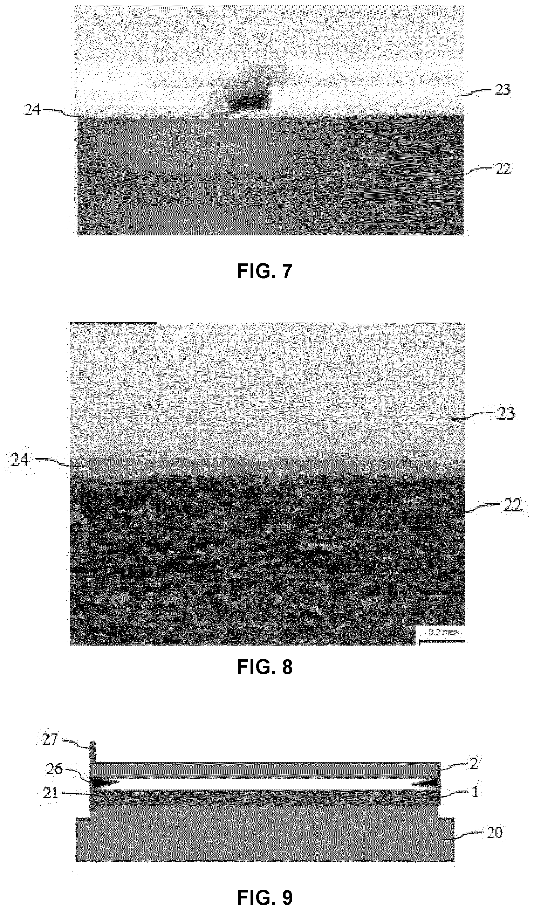

Un tel support 20 est représenté en vue du dessus sur les figures 5 et 6 et en vue de côté sur les figures 7 et 8. Ce support est configuré pour recevoir un substrat, dit premier substrat, qui peut être le substrat donneur 1 ou le substrat receveur 2, dont une face vient au contact de la surface d'appui 21 du support. Il comprend généralement un châssis métallique 22 revêtu d'une couche de polytétrafluoroéthylène (PTFE, connu notamment sous la marque TEFLON^{™}) 23. La couche de TEFLON^{™} est collée au châssis par l'intermédiaire d'une couche de colle 24.

Le premier substrat 1 est maintenu centré sur le support 20 grâce à des pièces de centrage 25, appelées « pusher » en anglais, qui viennent en butée contre la tranche du substrat.

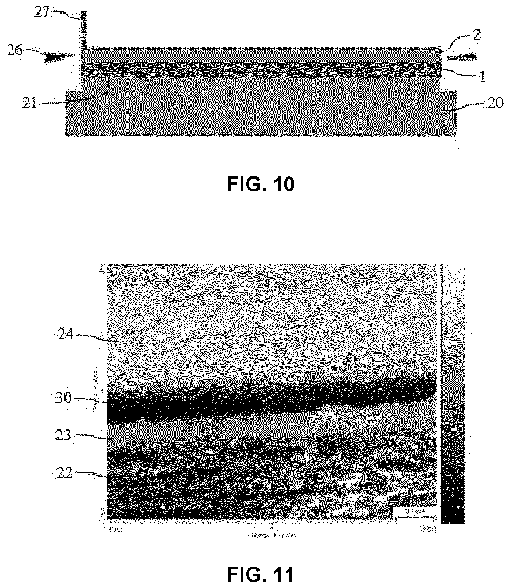

Des pièces d'espacement 26, dits écarteurs ou « spacer » en anglais, permettent de maintenir les deux substrats à distance l'un de l'autre avant collage. Les pièces d'espacement 26 sont également schématisées sur les figures 9 et 10 qui illustrent le positionnement du premier substrat 1 et du deuxième substrat 2 avant et après collage.

En référence à la figure 9, avant collage, le premier substrat 1 est positionné sur la surface d'appui 21 du support 20, et le deuxième substrat 2 est monté sur le support de sorte que les surfaces des deux substrats destinées à former l'interface de collage soient sont en regard l'une de l'autre. Les deux substrats sont maintenus séparés l'une de l'autre par les écarteurs 26.

Le support 20 est muni d'une quille 27, dite « notch pin » en anglais, permettant à un utilisateur de positionner les deux substrats de manière à ce que leurs encoches 5 servant à repérer leur positionnement soient alignées avec la quille 27, en plus de jouer le rôle de butée pour les substrats. Une deuxième butée 28 est également située à côté d'une des pièces de centrage 25. Grâce à la structure du support, l'utilisateur est assuré que les deux substrats sont correctement positionnés sur ledit support pour le collage.

En référence à la figure 10, les écarteurs 26 sont retirés afin de permettre le collage des deux substrats. La zone d'amorçage 13 du collage est située au niveau de la quille 27 du support.

Selon l'invention, le support 20 est déformé préalablement au positionnement du substrat donneur 1 et/ou receveur 2 sur sa surface d'appui 21. Plus précisément, le support est déformé de manière à ce que sa surface d'appui 21 présente une zone surélevée 29 par rapport au reste de ladite surface d'appui. Cette zone surélevée 29 est située au niveau de la zone de terminaison 14 de l'onde de collage, diamétralement opposée à la zone d'amorçage 13 de l'onde de collage.

La zone surélevée 29 peut être formée par soulèvement de la couche de PTFE, comme l'illustre la figure 11. La colle se dissocie localement, ce qui conduit à la formation d'un espace d'air 30 entre la couche de PTFE 23 et la colle restante sur le châssis 22.

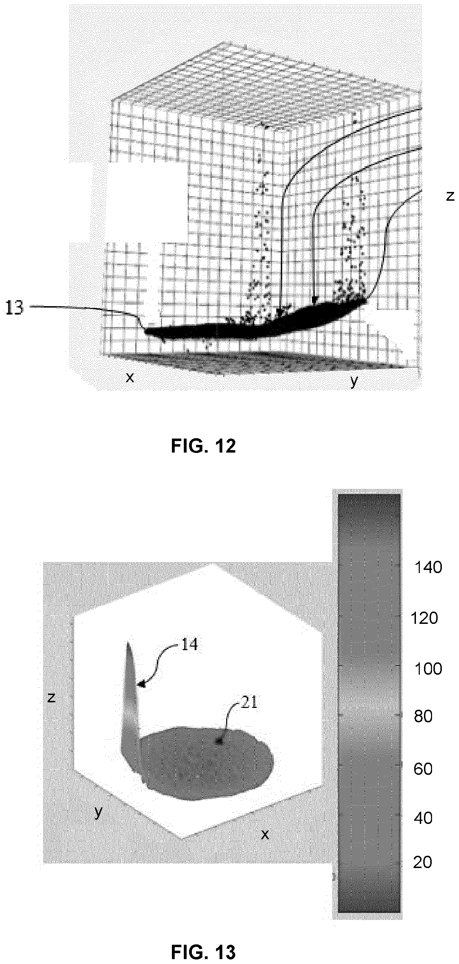

La figure 12 est une distribution de points issue d'une mesure de planarité du support, qui illustre le profil de la surface d'appui du support après déformation, selon trois axe x, y, z. On remarque que la surface d'appui 21 s'étend davantage le long de l'axe z au niveau de la zone de terminaison 14 de l'onde de collage que la zone d'amorçage 13, du fait de la présence de la zone surélevée 29.

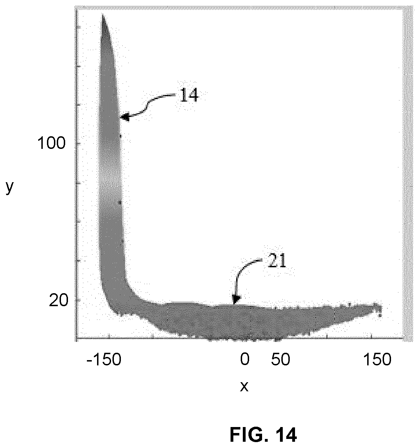

Les figures 13 et 14 illustrent également la déformation de la surface d'appui 21 du support au niveau de la zone de terminaison 14 de l'onde de collage qui s'étend jusqu'à environ 160 mm en hauteur (axe z) contre des valeurs allant de 0 mm à 20 mm pour le reste de la surface d'appui.

Le premier substrat, donneur ou receveur, est ensuite positionné sur la surface d'appui ainsi déformée du support. L'encoche 5 du premier substrat 1 est alignée avec la quille 27 du support. La surface exposée du premier substrat, qui est destinée à former l'interface de collage, se conforme alors au moins partiellement à la surface d'appui du support, de manière à présenter une zone surélevée 29 par rapport au reste de la surface exposée.

La zone surélevée 29 de la surface exposée du premier substrat est située à l'aplomb de la zone surélevée de la surface d'appui du support.

De préférence, la zone surélevée 29 de la surface exposée du premier substrat est surélevée par rapport au reste de la surface exposée de 15 µm à 150 µm, et de manière davantage préférée entre 20 µm et 100 µm.

On procède ensuite au collage du premier substrat 1, qui reste en position sur le support 20, avec le deuxième substrat 2. L'onde de collage est amorcée au niveau des encoches 5 des deux substrats par contact desdits substrats, et se propage à l'interface de collage 10 au fur et à mesure du rapprochement des substrats l'un de l'autre, jusqu'à la zone surélevée 29 de la surface exposée du premier substrat.

Le profil non uniforme de la surface d'appui du support conduit à la formation correspondante d'un profil non uniforme de la surface libre du premier substrat. Cette modification de l'état de surface de ladite surface libre, entre la zone surélevée et le reste de l'interface de collage, accroit la différence de vitesse de l'onde de collage entre la partie centrale et la partie périphérique de l'interface de collage. Ceci conduit à la formation des inclusions de gaz à l'interface de collage à l'aplomb de la zone surélevée du premier substrat.

Selon un deuxième mode de réalisation, la vitesse de propagation de l'onde de collage est contrôlée par l'application sélective d'un plasma sur la surface exposée du substrat donneur et/ou du substrat receveur destinée à former l'interface de collage.

La quantité de plasma appliquée sur la partie périphérique de la surface exposée du substrat est supérieure à celle appliquée sur la partie centrale de ladite surface exposée.

Le plasma modifie l'état de surface de la surface exposée en accélérant localement l'onde de collage. Sa distribution non uniforme accroit la différence de vitesse de l'onde de collage entre la partie centrale et la partie périphérique de l'interface de collage, ce qui conduit à la formation des inclusions de gaz à l'interface de collage à l'aplomb de la zone surélevée du premier substrat.

Le procédé de l'invention est réalisé à des températures plus basses que les procédés connus utilisant un recuit thermique à haute température dit « T-split », ce qui diminue les contraintes dans les substrats donneur et receveur, et diminue la rugosité de la surface libre de la structure après détachement. Il devient donc possible de se passer, ou tout du moins de limiter, des traitements ultérieurs de lissage, tel que le RTA.

## Revendications

1. Procédé de fabrication d'une structure de type semi-conducteur sur isolant, comprenant les étapes suivantes :
- fourniture d'un substrat donneur (1) comprenant une zone de fragilisation délimitant une couche à transférer,
- fourniture d'un substrat receveur (2),
- collage du substrat donneur (1) sur le substrat receveur (2), la couche à transférer étant située du côté de l'interface de collage (10), par initiation d'une onde de collage (3) à partir d'une première région (13) de la périphérie (11) de ladite interface et propagation de ladite onde vers une seconde région (14) de la périphérie (11) de ladite interface opposée à la première région (13), la vitesse de propagation de l'onde de collage (3) étant plus faible dans ladite partie centrale (12) que dans ladite partie périphérique (11),
- détachement du substrat donneur (1) le long de la zone de fragilisation pour transférer la couche à transférer sur le substrat receveur (2),
ledit procédé étant **caractérisé en ce que** le collage est mis en oeuvre dans des conditions contrôlées pour augmenter la différence de vitesse de propagation de ladite onde de collage entre la partie périphérique (11) et la partie centrale (12) de l'interface de collage (10).

2. Procédé selon la revendication 1, dans lequel ladite augmentation de la différence de vitesse de propagation de l'onde de collage est suffisante pour former une inclusion gazeuse (4) dans la seconde région (14) de la périphérie (11) de l'interface de collage.

3. Procédé selon la revendication 2, dans lequel le détachement du substrat donneur (1) est amorcé au niveau de l'inclusion gazeuse (4).

4. Procédé selon l'une quelconque des revendications précédentes, dans lequel les conditions de collage contrôlées comprennent le positionnement du substrat donneur (1) et/ou du substrat receveur (2), préalablement au collage, sur une surface d'appui (21) d'un support (20), ladite surface d'appui (21) présentant une zone surélevée (29) par rapport au reste de la surface d'appui, la surface exposée du substrat donneur (1) et/ou du substrat receveur (2) destinée à former l'interface de collage (10) étant au moins partiellement conformée à la surface d'appui (21) du support de manière à présenter une zone surélevée par rapport au reste de la surface exposée.

5. Procédé selon la revendication 4, dans lequel la zone surélevée de la surface exposée du substrat donneur (1) et/ou du substrat receveur (2) est surélevée par rapport au reste de la surface exposée de 15 µm à 150 µm.

6. Procédé selon l'une quelconque des revendications précédentes, dans lequel les conditions de collage contrôlées comprennent l'application sélective d'un plasma sur la surface exposée du substrat donneur (1) et/ou du substrat receveur (2) destinée à former l'interface de collage (10), la quantité de plasma appliquée sur la partie périphérique (11) de ladite surface exposée étant supérieure à celle appliquée sur la partie centrale (12) de ladite surface exposée.

7. Procédé selon l'une quelconque des revendications précédentes, dans lequel la zone de fragilisation est formée par implantation d'espèces atomiques dans le substrat donneur (1).

## Patentansprüche

1. Verfahren zur Herstellung einer Struktur vom Typ Halbleiter auf Isolator, die folgenden Schritte umfassend:
- Bereitstellung eines Donatorsubstrats (1), eine Versprödungszone umfassend, die eine zu transferierende Schicht abgrenzt,
- Bereitstellung eines Empfängersubstrats (2),
- Verklebung des Donatorsubstrats (1) auf das Empfängersubstrat (2), wobei die zu transferierende Schicht auf der Seite der Verklebungsschnittstelle (10) liegt, durch Initiieren einer Verklebungswelle (3) ausgehend von einem ersten Bereich (13) der Peripherie (11) der Schnittstelle und Ausbreitung der Welle zu einem zweiten Bereich (14) der Peripherie (11) der Schnittstelle, gegenüber dem ersten Bereich (13), wobei die Ausbreitungsgeschwindigkeit der Verklebungswelle (3) im zentralen Teil (12) niedriger ist als im peripheren Teil (11),
- Ablösung des Donatorsubstrats (1) entlang der Versprödungszone, um die zu transferierende Schicht auf das Empfängersubstrat (2) zu transferieren,
wobei das Verfahren **dadurch gekennzeichnet ist, dass** die Verklebung unter kontrollierten Bedingungen durchgeführt wird, um die Differenz in der Ausbreitungsgeschwindigkeit der Verklebungswelle zwischen dem peripheren Teil (11) und dem zentralen Teil (12) der Verklebungsschnittstelle (10) zu erhöhen.

2. Verfahren nach Anspruch 1, wobei die Erhöhung der Differenz in der Ausbreitungsgeschwindigkeit der Verklebungswelle ausreicht, um einen Gaseinschluss (4) im zweiten Bereich (14) der Peripherie (11) der Verklebungsschnittstelle zu bilden.

3. Verfahren nach Anspruch 2, wobei die Ablösung des Donatorsubstrats (1) im Bereich des Gaseinschlusses (4) initiiert wird.

4. Verfahren nach einem der vorhergehenden Ansprüche, wobei die Bedingungen der kontrollierten Verklebung das Positionieren des Donatorsubstrats (1) und/oder des Empfängersubstrats (2), vor der Verklebung auf einer Auflagefläche (21) eines Trägers (20), umfassen, wobei die Auflagefläche (21) eine relativ zum Rest der Auflagefläche erhöhte Zone (29) aufweist, wobei die freiliegende Oberfläche des Donatorsubstrats (1) und/oder des Empfängersubstrats (2), die zur Bildung der Verklebungsschnittstelle (10) bestimmt ist, mindestens teilweise an die Auflagefläche (21) des Trägers angepasst ist, so dass sie eine relativ zum Rest der freiliegenden Oberfläche erhöhte Zone aufweist.

5. Verfahren nach Anspruch 4, wobei die erhöhte Zone der freiliegenden Oberfläche des Donatorsubstrats (1) und/oder des Empfängersubstrats (2) relativ zum Rest der freiliegenden Oberfläche um 15 µm bis 150 µm erhöht ist.

6. Verfahren nach einem der vorhergehenden Ansprüche, wobei die Bedingungen der kontrollierten Verklebung das selektive Aufbringen eines Plasmas auf die freiliegende Oberfläche des Donatorsubstrats (1) und/oder des Empfängersubstrats (2) umfassen, die zur Bildung der Verklebungsschnittstelle (10) bestimmt ist, wobei die Plasmamenge, die auf den peripheren Teil (11) der freiliegenden Oberfläche aufgebracht wird, größer ist als diejenige, die auf den zentralen Teil (12) der freiliegenden Oberfläche aufgebracht wird.

7. Verfahren nach einem der vorhergehenden Ansprüche, wobei die Versprödungszone durch Implantation von atomaren Spezies in das Donatorsubstrat (1) gebildet wird.

## Claims

1. A method of manufacturing a semiconductor-on-insulator structure, comprising the following steps:
- providing a donor substrate (1) comprising an embrittlement zone delimiting a layer to be transferred,
- providing a receiver substrate (2),
- bonding the donor substrate (1) to the receiver substrate (2), the layer to be transferred being located on the bonding interface side (10) by initiating a bonding wave (3) from a first region (13) of the periphery (11) of said interface and propagating said wave to a second region (14) of the periphery (11) of said interface opposite to the first region (13), the propagation speed of the bonding wave (3) being lower in said central portion (12) than in said peripheral portion (11),
- detachment of the donor substrate (1) along the embrittlement zone in order to transfer the layer to be transferred onto the receiver substrate (2),
said method being **characterized in that** the bonding is carried out under controlled conditions to increase the difference in propagation speed of said bonding wave between the peripheral portion (11) and the central portion (12) of the bonding interface (10).

2. The method of claim 1, wherein said increase in the difference in propagation speed of the bonding wave is sufficient to form a gas inclusion (4) in the second region (14) of the periphery (11) of the bonding interface.

3. The method of claim 2, wherein the detachment of the donor substrate (1) is initiated at the gas inclusion (4).

4. The method according to any one of the preceding claims, wherein the controlled bonding conditions comprise positioning the donor substrate (1) and/or the receiver substrate (2), prior to bonding, on a bearing surface (21) of a support (20), said bearing surface (21) having a raised area (29) with respect to the rest of the bearing surface, the exposed surface of the donor substrate (1) and/or of the receiver substrate (2) intended to form the bonding interface (10) being at least partially shaped to the bearing surface (21) of the support in such a way that it has a region that is raised relative to the rest of the exposed surface.

5. The method of claim 4, wherein the raised area of the exposed surface of the donor substrate (1) and/or the receiver substrate (2) is raised relative to the rest of the exposed surface by 15 µm to 150 µm.

6. The method according to any one of the preceding claims, wherein the controlled bonding conditions comprise selectively applying a plasma to the exposed surface of the donor substrate (1) and/or the receiver substrate (2) intended to form the bonding interface (10), the amount of plasma applied to the peripheral portion (11) of said exposed surface being greater than that applied to the central portion (12) of said exposed surface.

7. The method according to any one of the preceding claims, wherein the embrittlement zone is formed by implantation of atomic species into the donor substrate (1).
